# EUROPÄISCHE PATENTSCHRIFT

(11) **EP 2 689 166 B1**
(45) Veröffentlichungstag und Bekanntmachung des Hinweises auf die Patenterteilung: **24.06.2015**
(21) Anmeldenummer: 12717150.2
(22) Anmeldetag: 02.02.2012
(51) Int. Cl.: F16J 9/26, C23C 8/04, C23C 14/06, C23C 14/22, C23C 28/00, C23C 28/02, C23C 30/00

(54) **VERFAHREN ZUR HERSTELLUNG VON KOLBENRINGEN**
METHOD FOR PRODUCING PISTON RINGS
PROCÉDÉ POUR PRODUIRE DES SEGMENTS DE PISTON

(30) Priorität: 19.03.2011 DE 102011014483
(43) Veröffentlichungstag der Anmeldung: 29.01.2014
(73) Patentinhaber: Federal-Mogul Burscheid GmbH, 51399 Burscheid (DE)
(72) Erfinder: ESSER, Peter-Klaus, 51515 Kürten (DE)
(74) Vertreter: Döpp, Ludger
(86) Internationale Anmeldenummer: PCT/DE2012/000087
(87) Internationale Veröffentlichungsnummer: WO 2012/126446

(56) Entgegenhaltungen:
- DE-A1- 10 221 800
- DE-A1-102005 023 627
- DE-B3- 10 359 802
- GB-A- 2 136 089

## Beschreibung

Die Erfindung betrifft ein Verfahren zur Herstellung eines mit einer verschleißfesten Schicht versehenen gekammerten Stahlkolbenrings.

Die DE 102 21 800 A1 offenbart ein Verfahren zur Erzeugung von Verschleißschutzschichten an einem Stahlkolbenring, indem die Lauffläche in einem ersten Arbeitsschritt zumindest partiell mit einer Laufflächenbeschichtung versehen wird und zur Erzeugung einer Härte HV 0,1 > 1400 in einem zweiten Arbeitsschritt zumindest die Flanken durch Plasmanitrieren mit einer Nitrierschicht versehen werden, dergestalt, dass der Arbeitsschritt des Plasmanitrierens in Abhängigkeit von der zum Einsatz gelangenden Laufflächenbeschichtung im Temperaturbereich < 490°C durchgeführt wird.

Durch die DE 10 2005 023 627 A1 ist ein Stahlkolbenring bekannt geworden, mit einer einseitig gekammerten Lauffläche, oberen und unteren Flanken sowie einer inneren Umfangsfläche, wobei die Lauffläche mit einer Mikrorisse aufweisenden Verschleißschutzschicht auf Basis von Chromkeramik überzogen ist und zumindest die Flanken mit einer Verschleiß reduzierenden Nitrierschicht versehen sind, dergestalt, dass mindestens einer der Übergangsbereiche der Flanke in die Lauffläche annähernd scharfkantig ausgebildet ist.

Bei der Ausführung eines gekammerten PVD-beschichteten Stahlkolbenrings besteht die Forderung nach einer scharfen Funktionskante. Da die Notwendigkeit einer Oberflächennitrierung gegeben ist, schließt sich dies bisher aus. Eine nitrierte Kante benötigt einen Kantenradius von max. 0,1 mm.

Unter einer serienmäßig hergestellten scharfen Kante versteht der Fachmann eine Verrundung von max. R < 0,05 mm.

Der Erfindung liegt die Aufgabe zugrunde, ein alternatives Verfahren zur Herstellung eines mit einer verschleißfesten Schicht versehenen gekammerten Stahlkolbenrings bereitzustellen, mit welchem eine scharfe Funktionskante im Übergangsbereich zwischen einer Flanke in die Lauffläche realisierbar ist.

Die Aufgabe wird gelöst durch ein Verfahren zur Herstellung eines mit einer verschleißfesten Schicht versehenen gekammerten Stahlkolbenrings, indem ein laufflächenseitig mit einer Kammerung versehener Grundkörper erzeugt wird, der Übergangsbereich einer Flanke des Grundkörpers in die Lauffläche dergestalt bearbeitet wird, dass eine Fase entsteht, die Lauffläche sowie zumindest Teile der Fase mit einer verschleißfesten Schicht versehen wird, die nicht mit der verschleißfesten Schicht versehene Umfangs- und Flankenbereiche des Grundkörpers dergestalt nitriert werden, dass im fasenseitigen Bereich der Flanke ein Abschnitt definierter Breite verbleibt, der keine Nitrierschicht aufweist und abschließend zumindest die verschleißfeste Schicht so weit abgetragen wird, dass eine im Wesentlichen scharfe, jedoch nicht nitrierte Funktionskante im Übergangsbereich der Flanke in die Lauffläche entsteht.

Vorteilhafte Weiterbildungen des erfindungsgemäßen Verfahrens sind den verfahrensgemäßen Unteransprüchen zu entnehmen.

Das erfindungsgemäße Verfahren ist vorteilhafterweise einsetzbar für einen Kompressionskolbenring für eine Brennkraftmaschine.

Die Fase wird, einem weiteren Gedanken der Erfindung gemäß, mechanisch, insbesondere durch Schleifen, erzeugt.

Auf die die Kammerung enthaltende Lauffläche kann bedarfsweise unmittelbar eine Chromschicht aufgebracht werden.

Alternativ besteht auch die Möglichkeit, auf die Lauffläche eine dünne PVD- (physical vapor deposition) oder eine DLC-Schicht (diamond like carbon) aufzubringen.

Je nach Anwendungsfall besteht auch die Möglichkeit, auf eine PVD- oder DLC-Schicht als weitere verschleißfeste Schicht eine Chromschicht aufzubringen.

Der Fachmann wird, in Abhängigkeit vom jeweiligen Anwendungsfall, die geeignete(n) Verschleißschutzschicht(en) auswählen.

Einem weiteren Gedanken der Erfindung gemäß werden zur Optimierung des Herstellungsprozesses vor dem Aufbringen der verschleißfesten Schicht mindestens zwei Grundkörper zu einem Paket zusammengefasst. In diesem Zustand kann dann die eine oder andere verschleißfeste Schicht mittels bekannter Verfahren aufgebracht werden.

Hier besteht die Möglichkeit, jeweils zwei Grundkörper mit aufeinander zu gerichteten Fasen oder aber mehrere (> 2) Grundkörper mit hintereinander liegenden Fasen zu einem Paket zusammenzufassen.

Bedingt durch die Fase im jeweiligen Grundkörper ist bei einander gegenüberliegenden Fasen ein etwa keilartiger Einschnitt gegeben, der gewährleistet, dass beim Aufbringen der verschleißfesten Schicht selbige auch im jeweiligen Fasenbereich zumindest partiell abgeschieden werden kann.

Bei axial hintereinander liegenden Grundkörpern können mehr als zwei Grundkörper zu einem Paket zusammengefasst werden, wodurch die Wirtschaftlichkeit noch erhöht werden kann.

Damit eine scharfe Funktionskante, gebildet aus dem Material des Grundkörpers, erzeugt werden kann, wird, einem weiteren Gedanken der Erfindung gemäß, vorgeschlagen, dass der nitrierfreie Abschnitt auf der zugehörigen Flanke 0,1 bis 1,5 mm beträgt.

Der abschließende Arbeitsvorgang sieht vor, dass zumindest die verschleißfeste Schicht außerhalb der Kammerung mechanisch, insbesondere durch Schleifen, von der Lauffläche entfernt wird. Das Material des Grundkörpers wird bedarfsweise bis auf den Ansatz der Fase an der Flanke abgeschliffen, so dass im fertigen Zustand des Stahlkolbenrings die Nitrierschicht immer noch um einen Betrag von etwa 0,05 bis 0,7 mm von der Lauffläche entfernt ist.

Somit kann durch das erfindungsgemäße Verfahren an einem gekammerten Stahlkolbenrings eine scharfe, jedoch unnitrierte Funktionskante im Übergangsbereich zwischen der jeweiligen Flanke und der Lauffläche erzeugt werden.

Die jeweilige Funktionskante wird vorteilhafterweise im Übergangsbereich der unteren, d.h. dem Zylinderkurbelgehäuse zugewandten Flanke und der Lauffläche gebildet und trägt so dazu bei, dass auch außerhalb des mindestens einen Ölabstreifrings ein Abstreifen von Restöl möglich ist.

Der Erfindungsgegenstand ist anhand eines Ausführungsbeispiels in der Zeichnung dargestellt und wird wie folgt beschrieben. Es zeigen:
- Figur 1: gekammerter Stahlkolbenring vor der Beschichtung;
- Figur 2: gekammerter Kolbenring gemäß Figur 1 mit angebrachter Fase;
- Figuren 3 und 4: alternative Paketierungsverfahren von Grundkörpern gemäß Figur 2;
- Figuren 5 und 6: alternative Beschichtungsverfahren der in den Figuren 3 und 4 dargestellten paketierten Grundkörper;
- Figur 7: Prinzipskizze eines mit einer PVD-Schicht versehenen Grundkörpers;
- Figur 8: Prinzipskizze eines mit einer PVD-Schicht versehenen und nitrierten Grundkörpers;
- Figur 9: Grundkörper gemäß Figur 8, jedoch mit einer auf der PVD-Schicht aufgebrachten Chromschicht,
- Figur 10: fertiger Kolbenring mit scharfer unnitrierter Funktionskante.

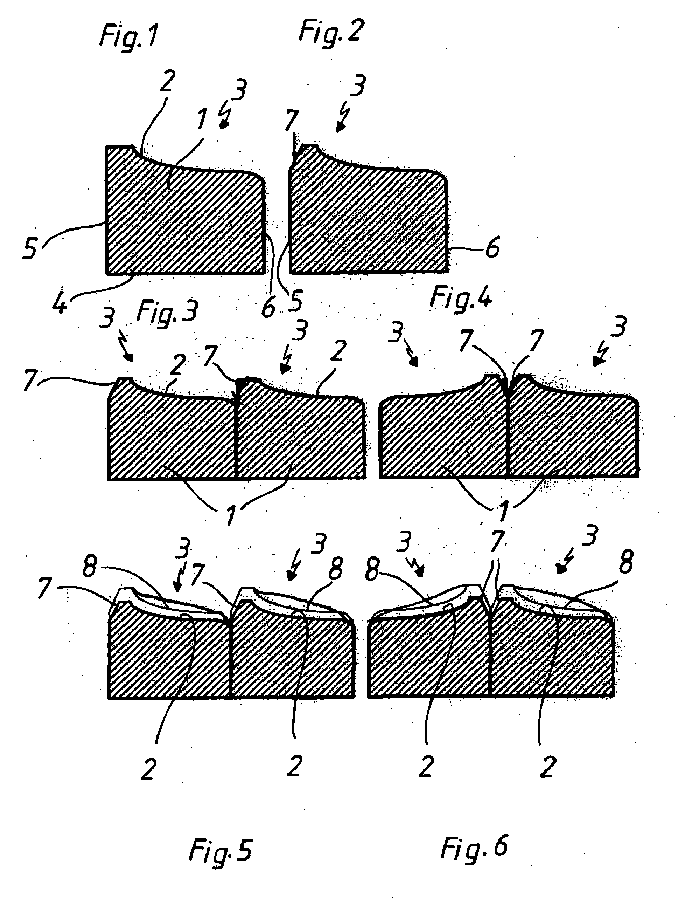

Figur 1 zeigt einen aus Stahl bestehenden Kolbenringgrundkörper 1, beinhaltend eine mit einer Kammerung 2 versehene Lauffläche 3, eine innere Umfangsfläche 4, eine untere, d.h im Einbauzustand einem nicht dargestellten Zylinderkurbelgehäuse zugewandten, Flanke 5 sowie eine obere, d.h. im Einbauzustand einem nicht dargestellten Brennraum zugewandte, Flanke 6. Dieser Grundkörper 1 bildet die Ausgangsform für den späteren, als Kompfessionskolbenring einsetzbaren Kolbenring.

Figur 2 zeigt, dass der Übergangsbereich von der Flanke 5 in die Lauffläche 3 dergestalt bearbeitet wurde, dass, beispielsweise durch Schleifen, eine Fase 7 gebildet wird:

Die Figuren 3 und 4 zeigen unterschiedliche Paketierungsverfahren für Grundkörper 1 gemäß Figur 2.

In Figur 3 sind mehrere Grundkörper 1 axial hintereinander angeordnet, wobei die Fasen 7 ebenfalls axial hintereinander liegen. Durch die in Richtung der jeweiligen Fase 7 auslaufende Kammerung 2 bestehen bei der Beschichtung der Lauffläche 3 keine Probleme auch die Fase 7 zumindest partiell mit Beschichtungsmaterial zu versehen.

Figur 4 zeigt, dass zwei Grundkörper 1 mit einander zugewandten Fasen 7 paarweise angeordnet sind, so dass eine Art Keil gebildet wird. Auch hier kann bei der Beschichtung der Lauffläche 3 Beschichtungsmaterial in den Bereich der Fase 7 eingebracht werden.

Die Figuren 5 und 6 zeigen Beschichtungen der Lauffläche 3, und zwar bezogen auf die Figuren 3 und 4.

In diesen Beispielen soll im Bereich der jeweiligen Lauffläche 3 eine verschleißfeste Chromschicht 8 aufgebracht werden, die unmittelbar auf den gekammerten Bereich 2 und die verbleibenden Bereiche der Lauffläche 3 aufgebracht wird. Die jeweilige Schicht 8 setzt sich auch, zumindest auf einem großen Teil der Fase 7, ab.

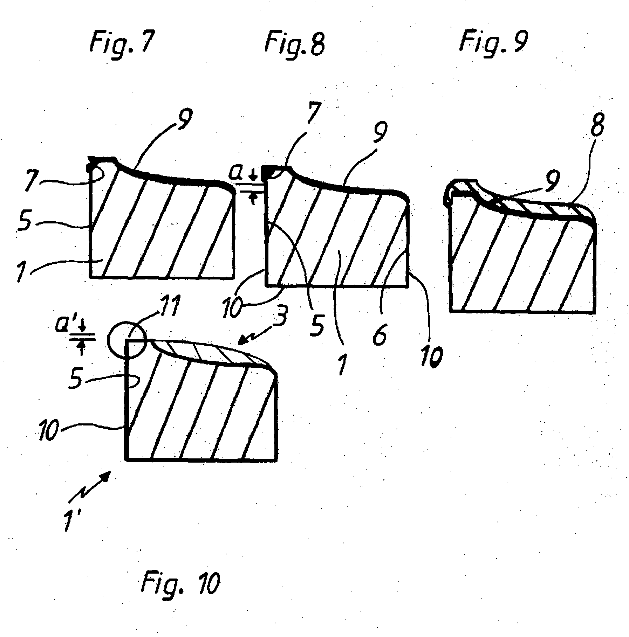

Figur 7 zeigt einen einzelnen Grundkörper 1, der mit einer PVD-Schicht 9 mit einer Schichtdicke zwischen 1 und 5 µm beschichtet wurde. In Analogie zu den Figuren 5 und 6 sind die mit der Fase 7 versehenen Flankenbereiche 5 ebenfalls von der PVD-Schicht zumindest partiell überzogen.

In Figur 8 ist erkennbar, dass der gemäß Figur 7 PVD beschichtete Grundkörper 1 außerhalb der PVD-Schicht 9 nitriert wurde. Die Nitrierschicht 10 ist auf allen weiteren in Figur 1 dargestellten Umfangs- 4 und Flankerlbereichen 5,6 vorgesehen. Im Bereich der Flanke 5 reicht die Nitrierschicht 10 jedoch nicht vollständig bis an die Fase 7 heran, so dass ein nitrierschichtfreier Abschnitt a definierter Breite, z.B. 1,5 mm, gegeben ist.

In Figur 9 ist dargestellt, dass auf die PVD-Schicht 9 eine bereits in den Figuren 5 und 6 beschriebene Chromschicht 8 aufgebracht wurde. Es gelten die gleichen Verfahrensabläufe, wie bereits zur Figur 8 erläutert.

Figur 10 zeigt den fertigen Stahlkolbenring 1'. Die in den Figuren 8 und 9 dargestellten Schichten 8, 9 wurden so weit abgetragen, dass eine scharfe Funktionskante 11 im Übergangsbereich von der Flanke 5 in die Lauffläche 3 gebildet wurde, wobei die Nitrierschicht 10 mit definiertem Abstand a' zur Funktionskante 11, z. B. 0,5 mm, endet.

## Patentansprüche

1. Verfahren zur Herstellung eines, mit einer verschleißfesten Schicht (8,9) versehenen gekammerten Stahlkolbenrings (1'), indem ein laufflächenseitig mit einer Kammerung (2) versehener Grundkörper (1) erzeugt wird, der im Übergangsbereich einer Flanke (5) des Grundkörpers (1) in die Lauffläche (3) dergestalt bearbeitet wird, dass eine Fase (7) entsteht, die Lauffläche (3) sowie zumindest Teile der Fase (7) mit einer verschleißfesten Schicht (8,9) versehen wird, die nicht mit der verschleißfesten Schicht (8,9) versehene Umfangs- (4) und Flankenbereiche (5,6) des Grundkörpers (1) dergestalt nitriert werden, dass im fasenseitigen Bereich der Flanke (5) ein Abschnitt definierter Breite (a) verbleibt, der keine Nitrierschicht (10) aufweist und abschließend zumindest die verschleißfeste Schicht (8,9) so weit abgetragen wird, dass eine im Wesentlichen scharfe, jedoch nicht nitrierte Funktionskante (11) im Übergangsbereich der Flanke (5) in die Lauffläche (3) entsteht.

2. Verfahren nach Anspruch 1, **dadurch gekennzeichnet, dass** die Fase (7) durch Schleifen erzeugt wird.

3. Verfahren nach Anspruch 1 oder 2, **dadurch gekennzeichnet, dass** auf die die Kammerung (2) enthaltende Lauffläche (3) eine Chromschicht (8) aufgebracht wird.

4. Verfahren nach Anspruch 1 oder 2, **dadurch gekennzeichnet, dass** auf die Lauffläche (3) eine PVD- oder DLC-Schicht (9) aufgebracht wird.

5. Verfahren nach Anspruch 4, **dadurch gekennzeichnet, dass** auf die PVD- oder DLC-Schicht (9) eine Chromschicht (8) aufgebracht wird.

6. Verfahren nach Anspruch 1 oder 2, **dadurch gekennzeichnet, dass** vor Aufbringung der verschleißfesten Schicht (8,9) mindestens zwei Grundkörper (1) zu einem Paket zusammengefasst werden.

7. Verfahren nach Anspruch 6, **dadurch gekennzeichnet, dass** jeweils zwei Grundkörper (1) mit aufeinander zu gerichteten Fasen (7) zu einem Paket zusammengefasst werden.

8. Verfahren nach Anspruch 6, **dadurch gekennzeichnet, dass** mehrere Grundkörper (1) mit hintereinander liegenden Fasen (7) zu einem Paket zusammengefasst werden.

9. Verfahren nach einem der Ansprüche 1 bis 5, **dadurch gekennzeichnet, dass** der nitrierschichtfreie Abschnitt (a') auf der Flanke 0,1 bis 1,5 mm beträgt.

10. Verfahren nach einem der Ansprüche 1 bis 9, **dadurch gekennzeichnet, dass** zumindest die verschleißfeste Schicht (8,9) durch Schleifen von der die Kammerung enthaltende Lauffläche (3) entfernt wird.

11. Verfahren nach einem der Ansprüche 1 bis 10, **dadurch gekennzeichnet, dass** das Material des Grundkörpers (1) etwa bis auf den Ansatzbereich der Fase (7) an der Flanke (5) abgeschliffen wird.

12. Kompressionskolbenring, hergestellt nach einem der verfahrensgemäßen Ansprüche 1 bis 11.

## Claims

1. A method for manufacturing a chambered steel piston ring (1') provided with a wear-resistant layer (8, 9), in that a base body (1) is produced, the bearing surface of which is provided with a chambering (2), and which base body will be worked in the transition area of a flank (5) of the base body (1) into the bearing surface (3), such that a chamfer (7) is created, the bearing surface (3) as well as at least parts of the chamfer (7) will be provided with a wear-resistant layer (8, 9), the circumferential areas (4) and flank areas (5, 6) of the base body (1), which are not provided with the wear-resistant layer (8, 9), will be nitrided, such that in the area on the side of the chamfer of the flank (5) a section of defined width (a) will remain which does not comprise any nitrided layer (10), and finally at least the wear-resistant layer (8, 9) will be removed to such an extent that an essentially sharp, but not nitrided functional edge (11) will be created in the transition area of the flank (5) into the bearing surface (3).

2. A method according to claim 1, **characterized in that** the chamfer (7) will be produced by grinding.

3. A method according to claim 1 or 2, **characterized in that** a chromium layer (8) is applied onto the bearing surface (3) which comprises the chambering (2).

4. A method according to claim 1 or 2, **characterized in that** a PVD or DLC layer (9) will be applied onto the bearing surface (3).

5. A method according to claim 4, **characterized in that** a chromium layer (8) will be applied onto the PVD or DLC layer (9).

6. A method according to claim 1 or 2, **characterized in that** at least two base bodies (1) will be combined in a packet before the wear-resistant layer (8, 9) is applied.

7. A method according to claim 6, **characterized in that** respectively two base bodies (1) having chamfers (7) which are directed towards each other will be combined in a packet.

8. A method according to claim 6, **characterized in that** several base bodies (1) having chamfers (7) which are placed one behind the other will be combined in a packet.

9. A method according to one of the claims 1 through 5, **characterized in that** the section (a') without nitrided layer on the flank is comprised between 0.1 and 1.5 mm.

10. A method according to one of the claims 1 through 9, **characterized in that** at least the wear-resistant layer (8, 9) will be removed from the bearing surface (3) which contains the chambering by grinding.

11. A method according to one of the claims 1 through 10, **characterized in that** the material of the base body (1) will be ground approximately up to the contact area between the chamfer (7) and the flank (5).

12. A compression piston ring, manufactured according to one of the method claims 1 through 11.

## Revendications

1. Procédé de fabrication d'un segment de piston en acier (1'), qui est chambré et muni d'une couche résistante à l'usure (8, 9), en produisant un corps de base (1) dont la surface de glissement est munie d'un chambrage (2), le corps de base (1) étant usiné dans la zone de transition d'un flanc (5) du corps de base (1) dans la surface de glissement (1), de sorte qu'un chanfrein (7) est créé, la surface de glissement (3) ainsi qu'au moins des parties du chanfrein (7) étant munies d'une couche résistante à l'usure (8, 9), les zones circonférentielles (4) et les zones de flanc (5, 6) du corps de base (1), lesquelles ne sont pas munies de la couche résistante à l'usure (8, 9) étant nitrurées de façon que dans la zone du flanc (5) du côté du chanfrein demeure une section de largeur définie (a), laquelle section ne comprend pas de couche de nitruration (10), et finalement au moins la couche résistante à l'usure (8, 9) étant enlevée jusqu'au point qu'une arête fonctionnelle (11) essentiellement acérée, mais non nitrurée soit créée dans la zone de transition du flanc (5) dans la surface de glissement (3).

2. Procédé selon la revendication 1, **caractérisé en ce que** le chanfrein (7) est créé par meulage.

3. Procédé selon la revendication 1 ou la revendication 2, **caractérisé en ce qu'**une couche en chrome (8) est appliquée sur la surface de glissement (3) comprenant le chambrage (2).

4. Procédé selon la revendication 1 ou la revendication 2, **caractérisé en ce qu'**une couche en PVD ou en DLC (9) est appliquée sur la surface de glissement (3).

5. Procédé selon la revendication 4, **caractérisé en ce qu'**une couche en chrome (8) est appliquée sur la couche en PVD ou en DLC (9).

6. Procédé selon la revendication 1 ou la revendication 2, **caractérisé en ce qu'**au moins deux corps de base (1) sont combinés dans un paquet avant l'application de la couche résistante à l'usure (8, 9).

7. Procédé selon la revendication 6, **caractérisé en ce que** respectivement deux corps de base (1), dont les chanfreins (7) sont orientés l'un vers l'autre, sont combinés dans un paquet.

8. Procédé selon la revendication 6, **caractérisé en ce que** plusieurs corps de base (1), dont les chanfreins (7) sont disposés l'un derrière l'autre, sont combinés dans un paquet.

9. Procédé selon l'une des revendications 1 à 5, **caractérisé en ce que** la section (a') sans couche de nitruration sur le flanc est comprise entre 0,1 et 1,5 mm.

10. Procédé selon l'une des revendications 1 à 9, **caractérisé en ce qu'**au moins la couche résistante à l'usure (8, 9) est enlevée par meulage de la surface de glissement (3) comprenant le chambrage.

11. Procédé selon l'une des revendications 1 à 10, **caractérisé en ce que** le matériel du corps de base (1) est meulé jusqu'à approximativement la zone de contact entre le chanfrein (7) et le flanc (5).

12. Segment de piston de compression, fabriqué selon l'une des revendications de procédé 1 à 11.
